# EUROPEAN PATENT APPLICATION

(11) **EP 2 402 928 A1**
(43) Date of publication of application: **04.01.2012**
(21) Application number: 10745813.5
(22) Date of filing: 10.02.2010
(51) Int. Cl.: G09F 13/20, G09G 3/32, G09F 9/33

(54) **CHARACTER DISPLAY MODULE**

(30) Priority: 27.02.2009 CN 200910007924
(71) Applicant: Winstar Display Co., Ltd., Taichung City, Taiwan 40761 (TW)
(72) Inventor: LIAO, Yu-Pin, Taichung City Taiwan 40761 (CN); LIU, Ying-Ju, Taichung City Taiwan 40761 (CN)
(74) Representative: Lang, Christian
(86) International application number: PCT/CN2010/070598
(87) International publication number: WO 2010/097029

(57) **Abstract**

A character display module is disclosed, which includes a character organic light-emitting diode (OLED) panel, a printed circuit board (PCB) electrically connected with the character OLED panel, a drive controller which is set on the PCB and electrically connected with the character OLED panel to drive it, a frame that locates the character OLED panel on the PCB. So a lighter, thinner, high quality, lower cost and energy-saving character display module is provided.

## Description

### BACKGROUND OF THE INVENTION

### Field of the Invention

The present invention relates to a display module, and more particularly to a character display module.

### Description of the Prior Art

LCD (liquid crystal display) has become the mainstream of the FPD (flat panel display) in recent years, but the problem is that the LCD must use a backlight module as a light source, and the backlight module will not only increase the thickness and weight of the LCD but also require more power consumption. On top of that, the existing LCDs all have the disadvantages of narrow angle of view and slow response, which leads to image persistence.

The present invention has arisen to mitigate and/or obviate the afore-described disadvantages.

### SUMMARY OF THE INVENTION

The primary object of the present invention is to provide a character display module which comprises a character OLED panel.

To obviate the aforementioned disadvantages, the character display module in accordance with the present invention comprises: a character OLED (organic light emitting diode) panel, a polarizer, a PCB (printed circuit board), a drive controller, two conductive elements and a frame.

The character organic light emitting diode is of dot matrix type provided with a first connecting portion and a second connecting portion.

The polarizer is located in a light path of the character organic light emitting diode.

The printed circuit board is provided with a first assembling portion and a second assembling portion and provided at an inner side the first assembling portion with a first connecting portion to be aligned with the first connecting portion of the character organic light emitting diode, and provided at an inner side of the second assembling portion with a second connecting portion to be aligned with the second connecting portion of the character organic light emitting diode.

The drive controller includes a panel-control device and a panel-drive device.

The plurality of conductive elements are disposed between the character organic light emitting diode and the printed circuit board and are in contact with the first connecting portion of the printed circuit board and the first connecting portion of the character organic light emitting diode, and are further in contact with the second connecting portion of the printed circuit board and the second connecting portion of the character organic light emitting diode, respectively, and the character organic light emitting diode is driven and controlled by the panel-control device and the panel-drive device of the drive controller.

The frame is provided with a first positioning portion and a second positioning portion which are to be engaged with the assembling portion and the second assembling portion of the printed circuit board, respectively, so that the character organic light emitting diode is positioned on the printed circuit board by the frame.

The character organic light emitting diode is a 5x8 or 5x10 dot matrix panel driven and controlled by the panel-control device and the panel-drive device of the drive controller, each character is shown in a format of 5x8 or 5x10 dot matrix, characters are displayed in a 4x1 ∼ 100x1 or 4x40 - 4x100 matrix, and preferably in a 08x01, 08x02, 16x01, 16x02, 16x04, 20x01, 20x02, 20x04, 40x01, 40x02 or 40x04 matrix, the character organic light emitting diode 10 has a thickness of 0.4∼5mem, and preferably 0.4mm, 0.5mm, 0.55mm, 0.7mm, 1.0mm, 1.1mm, 1.4mm or 2.0mm, its Commission Internationale de l'Eclairage is between X 0.1∼0.8 and Y 0.1∼0.8, light efficiency is 0.65∼65 (lm/W), and its lifetime is 20k-2000k hours and above.

The polarizer has a wavelength of 1/2∼1/10, and preferably 1/4, and a wavelength of the light to be filtered by the polarizer ranges from 400nm to 700nm.

The panel-control device is provided with a micro control integrated circuit, a character generator read only memory, a character generator random access memory and an integrated reset circuit, the micro control integrated circuit is provided with 4bit and 8bit 6800/8080 parallel and serial ports, the character generator ROM is electrically connected to the micro control integrated circuit and has a 64x8 bit mutli-language database which includes west Europe, English-Japanese, English-Russian, and English-French, the character generator random access memory is electrically connected to the micro control integrated circuit and built-in with a 100x16 graphic function, the integrated reset circuit is electrically connected to the micro control integrated circuit, the panel-drive device sets resolution of the character organic light emitting diode and is electrically connected to the character generator read only memory and the character generator random access memory, the panel-drive device comprises a shared drive circuit, a section control circuit electrically connected to the shared drive circuit, and a power supply circuit electrically connected to the section control circuit, and the power supply circuit employs a DC/DC convertor to supply power to the panel-drive device.

The conductive elements are made of liquid, solid or colloid elastic conductive material, preferably take the forms of conductive rubber, silver glue, carbon powder, anisotropic conductive film, or flexible flat cable.

A thickness of the printed circuit board ranges from 0.2mm∼10mm, preferably 0.4mm, 0.6mm, 0.8mm, 1.0mm or 1.6mm, a resistor is electrically connected to the printed circuit board, and the first and second assembling portion, of the printed circuit board are each provided with slots and a hole for engaging with the first and second positioning portions of the frame.

The frame is metal or non-metal, the first and second positioning portions of the frame each include positioning protrusions, and three of the four positioning protrusions are provided with a deformable end, respectively, the positioning protrusions of the first positioning portion are inserted in the slots and the hole of the first assembling portion in such a manner that the deformable ends of the positioning protrusions are locked against the printed circuit board after inserting through the slots, similarly, the positioning protrusions of the second positioning portion are inserted in the slots and the hole of the second assembling portion, and the deformable ends of the positioning protrusions are locked against the printed circuit board, the first and second assembling portions of the printed circuit board are oppositely arranged, the first and second connecting portions of the character organic light emitting diode are oppositely arranged, and the first and second connecting portions of the printed circuit board are oppositely arranged.

The present invention has the following advantages:

It saves production cost and space since no backlight module is used. The present invention is energy saving since it is capable of converting electric energy into light. The character OLED panel provides high definition image, fast response time, full viewing angle and high effective contrast ratio.

The present invention is provided with a character generator ROM, a character generator RAM, an integrated reset circuit, a power supply circuit and character display module. The character generator ROM is built-in with language database, the character generator RAM is built-in with graphic function, the integrated reset circuit provides reset function, and the power supply circuit supplies power, such arrangements improve drive convenience and perfect functions.

### BRIEF DESCRIPTION OF THE DRAWINGS

Fig. 1 is an exploded view of a character display module in accordance with the present invention;
Fig. 2 is an assembly view of the character display module in accordance with the present invention;
Fig. 3 shows the circuit diagram of a drive controller of the character display module in accordance with the present invention;
Fig. 4 is an illustrative view showing the PCB and the frame of the character display module in accordance with the present invention;
Fig. 5 is another illustrative view showing the PCB and the frame of the character display module in accordance with the present invention;
Fig. 6 is a cross sectional view of the character display module in accordance with the present invention; and
Fig. 7 is an illustrative view showing that characters are shown in the character display module in accordance with the present invention.

### DETAILED DESCRIPTION OF THE PREFERRED EMBODIMENTS

The present invention will be clearer from the following description when viewed together with the accompanying drawings, which show, for purpose of illustrations only, the preferred embodiment in accordance with the present invention.

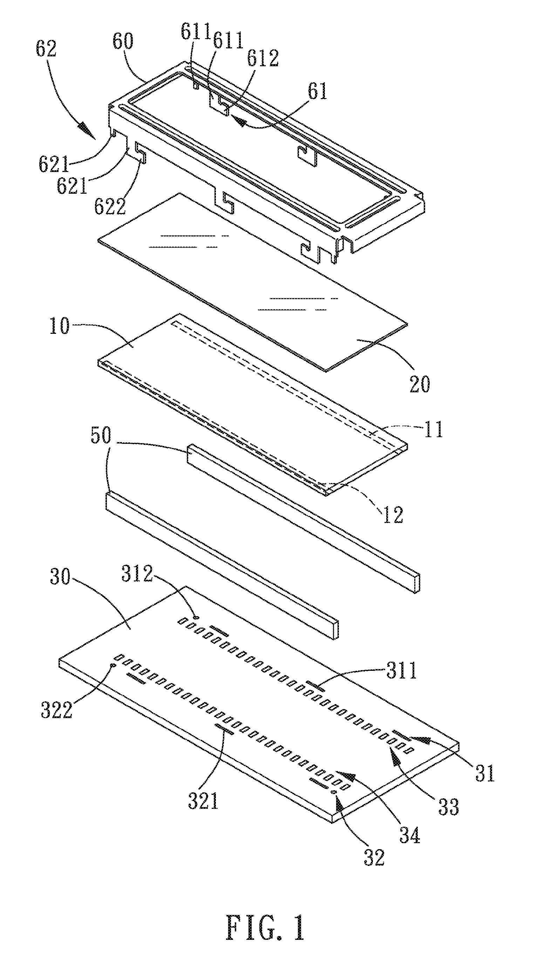

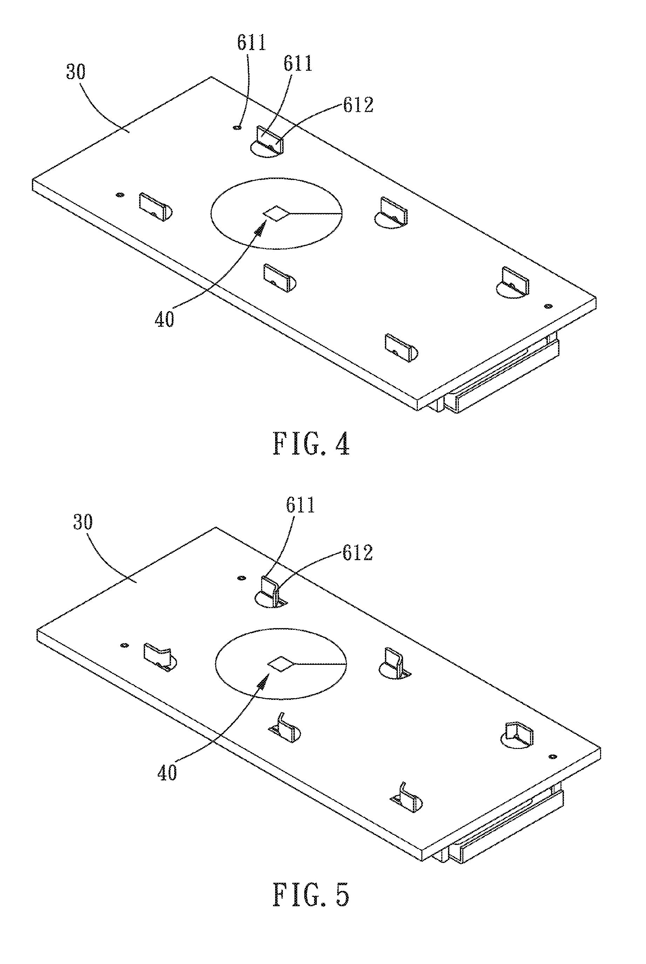

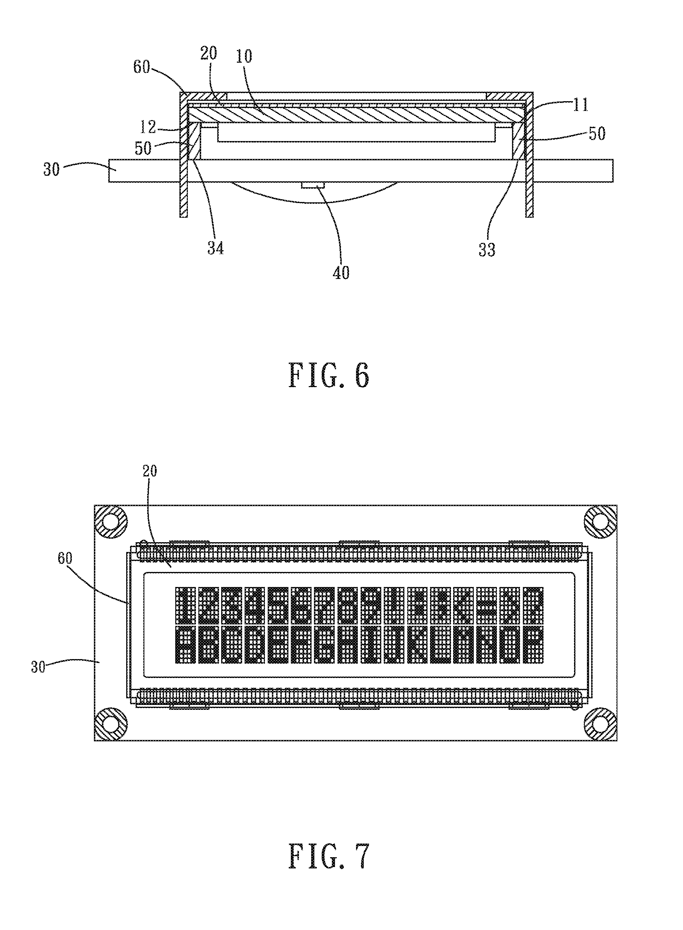

Referring to Figs. 1-7, a character display module in accordance with the present invention comprises: a character OLED (organic light emitting diode) panel 10, a polarizer 20, a PCB (printed circuit board) 30, a drive controller 40, two conductive elements 50 and a frame 60.

The character OLED panel 10 is a 5x8 or 5x10 dot matrix panel, which means that each character is shown in the format of 5x8 or 5x10 dot matrix, preferably, 5x8. Characters are displayed in a 4 (line) x 1 (column) - 100 (line) x 1 (column) or 4 (line) x 40 (column) - 4 (line) x 100 (column) matrix, and preferably in a 08 (line) x 01 (column), 08x02, 16x01, 16x02, 16x04, 20x01, 20x02, 20x04, 40x01, 40x02 or 40x04 matrix.

The character OLED panel 10 has a thickness of 0.4∼5mm, and preferably 0.4mm, 0.5mm, 0.55mm, 0.7mm, 1.0mm, 1.1mm, 1.4mm or 2.0mm, its CIE (Commission Internationale de l'Eclairage) is between X ranging from 0.1∼0.8 and Y ranging 0.1∼0.8, light efficiency is 0.65∼65 (lm/W), and its lifetime is 20k-2000k hours and above.

The character OLED panel 10 is provided at two opposite side thereof with a first connecting portion 11 and a second connecting portion 12.

The character OLED panel 10 of the present invention has the following advantages as compared to the conventional character LCD (liquid crystal display) panel:
1, self-luminescent device: photoelectric converting device capable of converting electric energy into light by exerting an electric field to produce light.
2, low voltage DC (direct current) drive (lower than 16V).
3, High Power Efficiency: only the self-luminescent pixels consume electric energy, the power required is much lower than the CRT (cathode ray tube) and TFT-LCD (thin film transistor-liquid crystal display), and self-luminescent device is power saving since it doesn't require the use of the high consumption backlight module.
4, High brightness: high definition image, and thanks to the features of the CRT and TFT-LC, the brightness of the present invention higher than 100000cd/m², and the characters can be clearly displayed even when the brightness is as low as 5 cd/m².
5. Fast response time: the response time of the character OLED panel 10 is counted by µsec, while the LCD is counted by msec. The response time of the character OLED panel 10 is over 1000 times than the 50 msec response time of the TFT-LCD and the 100 msec of the STN (Supertwisted-Nematic)-LCD, which reduces image distortion.
6. Light weight & Slim: the thickness of the character OLED panel 10 is substantially reduced to be thinner than 2mm since it doesn't need the use of backlight module.
7. High reliability: lifetime is longer than 100,000 hrs at the brightness of 100 cd/m², the OLED panel is more durable due to its simple structure, and therefore is suitable for applications there is high vibration and sharp temperature change.
8. Full viewing angle: viewing angle is larger than 175 degrees when looking down in the up, down, left and right directions.
9. Excellent uniformity.
10. High effective contrast ratio.

The polarizer 20 has a wavelength of 1/2∼1/10, and preferably 1/4, and the wavelength of the light to be filtered ranges from 400nm to 700nm. The polarizer 20 is located in the light path of the character OLED panel 10, which not only improves the contrast ratio of the character OLED panel 10 but also changes the color of the light through the polarizer 20 of different wavelengths.

The thickness of the PCB 30 ranges from 0.2 mm-10mm (preferably 0.4mm, 0.6mm, 0.8mm, 1.0mm or 1.6mm).

The PCB 30 is provided at two opposite sides thereof with a first assembling portion 31 and a second assembling portion 32. The first assembling portion 31 includes three slots 311 and a hole 312, and the second assembling portion 32 also includes three slots 321 and a hole 322. The first assembling portion 31 is provided at its inner side thereof with a first connecting portion 33 to be aligned with the first connecting portion 11 of the character OLED panel 10, while the second assembling portion 32 is also provided at its inner side thereof with a second connecting portion 34 to be aligned with the second connecting portion 12 of the character OLED panel 10. A resistor is electrically connected to the PCB 30 to adjust the brightness, power consumption (limiting current and increasing voltage conversion ratio can reduce power consumption) and pre-charging time.

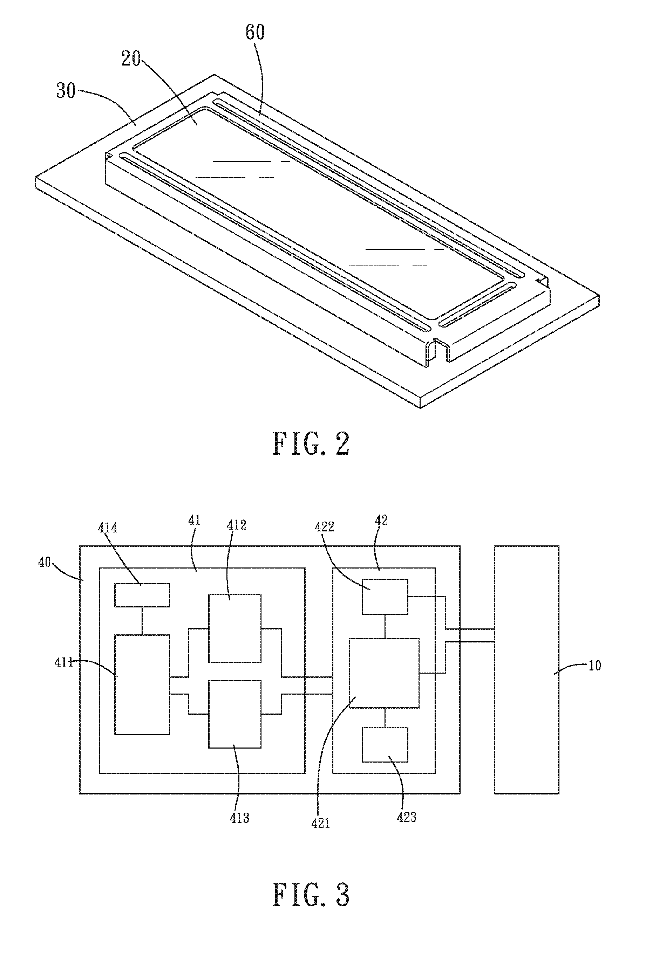

As shown in Fig. 3, the drive controller 40 comprises a panel-control device 41 and a panel-drive device 42.

The panel-control device 41 is provided with a micro control integrated circuit 411, a character generator ROM (read only memory) 412, a character generator RAM (random access memory) 413 and an integrated reset circuit 414. The micro control integrated circuit 411 is provided with 4bit and 8bit 6800/8080 parallel and serial ports. The character generator ROM 412 is electrically connected to the micro control integrated circuit 411 and has a 64x8 bit mutli-language database (including west Europe, English-Japanese, English-Russian, and English-French). The character generator RAM 413 is electrically connected to the micro control integrated circuit 411 and built-in with a 100x16 graphic function. The integrated reset circuit 414 is electrically connected to the micro control integrated circuit 411.

The panel-drive device 42 sets the resolution of the character OLED panel 10 at 5x8 or 5x10 dot matrix for each character and is electrically connected to the character generator ROM 412 and the character generator RAM 413. The panel-drive device 42 comprises a shared drive circuit 421, a section control circuit 422 electrically connected to the shared drive circuit 421, and a power supply circuit 423 electrically connected to the section control circuit 422. The shared drive circuit 421 and the section control circuit 422 are drivingly connected to the character OLED panel 10, and the power supply circuit 423 employs a DC/DC (direct current) convertor to supply power to the panel-drive device 42.

The conductive elements 50 are made of liquid, solid or colloid elastic conductive material [preferably take the form of conductive rubber, silver glue, carbon powder, ACF (Anisotropic Conductive Film), or FFC (flexible flat cable)] and are disposed between the character OLED panel 10 and the PCB 30 in such a manner that one of the conductive elements 50 is in contact with the first connecting portion 33 of the PCB 30 and the first connecting portion 11 of the character OLED panel 10, while the other conductive elements 50 is in contact with the second connecting portion 34 of the PCB 30 and the second connecting portion 12 of the character OLED panel 10, and the character OLED panel 10 is driven and controlled by the drive controller 40.

The frame 60 is metal (iron or stainless steel) or non-metal (plastic) and provided at two opposite sides thereof with a first positioning portion 61 and a second positioning portion 62 which are to be engaged with the assembling portion 31 and the second assembling portion 32 of the PCB 30, respectively. The first and second positioning portions 61 and 62 each include four positioning protrusions 611, 621, and three of the four positioning protrusions 611, 621 are provided with a deformable end 612, 622, respectively. The positioning protrusions 611 of the first positioning portion 61 are inserted in the slots 311 and the hole 312 of the first assembling portion 31 in such a manner that the deformable ends 612 of the positioning protrusions 611 are folded when passing through the slots 311 and finally recovered and locked against the PCB 30 after passing through the slots 311. similarly, the positioning protrusions 621 of the second positioning portion 62 are inserted in the slots 321 and the hole 322 of the second assembling portion 32, and the deformable ends 622 of the positioning protrusions 621 are locked against the PCB 30 after inserting through the slots 321.

While we have shown and described various embodiments in accordance with the present invention, it is clear to those skilled in the art that further embodiments may be made without departing from the scope of the present invention.

## Claims

1. A character display module comprising:
a character organic light emitting diode of dot matrix type provided with a first connecting portion and a second connecting portion;
a polarizer located in a light path of the character organic light emitting diode;
a printed circuit board provided with a first assembling portion and a second assembling portion and being provided at an inner side of the first assembling portion with a first connecting portion to be aligned with the first connecting portion of the character organic light emitting diode, and provided at an inner side of the second assembling portion with a second connecting portion to be aligned with the second connecting portion of the character organic light emitting diode;
a drive controller including a panel-control device and a panel-drive device;
a plurality of conductive elements disposed between the character organic light emitting diode and the printed circuit board and being in contact with the first connecting portion of the printed circuit board and the first connecting portion of the character organic light emitting diode, and in contact with the second connecting portion of the printed circuit board and the second connecting portion of the character organic light emitting diode, respectively, and the character organic light emitting diode is driven and controlled by the panel-control device and the panel-drive device of the drive controller; and
a frame provided with a first positioning portion and a second positioning portion which are to be engaged with the assembling portion and the second assembling portion of the printed circuit board, respectively, so that the character organic light emitting diode is positioned on the printed circuit board by the frame.

2. The character display module as claimed in claim 1, wherein the character organic light emitting diode is a 5x8 or 5x10 dot matrix panel driven and controlled by the panel-control device and the panel-drive device of the drive controller, each character is shown in a format of 5x8 or 5x10 dot matrix, characters are displayed in a 4x1 ∼ 100x1 or 4x40 - 4x100 matrix, and preferably in a 08x01, 08x02, 16x01,16x02,16x04,20x01,20x02,20x04,40x01,40x02 or 40x04 matrix, the character organic light emitting diode has a thickness of 0.4∼5mm, and preferably 0.4mm, 0.5mm, 0.55mm, 0.7mm, 1.0mm, 1.1mm, 1.4mm or 2.0mm, its Commission Internationale de l'Eclairage is between X 0.1∼0.8 and Y 0.1∼0.8, light efficiency is 0.65∼65 (lm/W), and its lifetime is 20k-2000k hours and above.

3. The character display module as claimed in claim 1, wherein the polarizer has a wavelength of 1/2∼1/10, and preferably 1/4, and a wavelength of the light to be filtered by the polarizer ranges from 400nm to 700nm.

4. The character display module as claimed in claim 1 or 2, wherein the panel-control device is provided with a micro control integrated circuit, a character generator read only memory, a character generator random access memory and an integrated reset circuit, the micro control integrated circuit is provided with 4bit and 8bit 6800/8080 parallel and serial ports, the character generator ROM is electrically connected to the micro control integrated circuit and has a 64x8 bit mutli-language database which includes west Europe, English-Japanese, English-Russian, and English-French, the character generator random access memory is electrically connected to the micro control integrated circuit and built-in with a 100x16 graphic function, the integrated reset circuit is electrically connected to the micro control integrated circuit, the panel-drive device sets resolution of the character organic light emitting diode and is electrically connected to the character generator read only memory and the character generator random access memory, the panel-drive device comprises a shared drive circuit, a section control circuit electrically connected to the shared drive circuit, and a power supply circuit electrically connected to the section control circuit, and the power supply circuit employs a DC/DC convertor to supply power to the panel-drive device.

5. The character display module as claimed in claim 1, wherein the conductive elements are made of liquid, solid or colloid elastic conductive material, preferably take the forms of conductive rubber, silver glue, carbon powder, anisotropic conductive film, or flexible flat cable.

6. The character display module as claimed in claim 1, wherein a thickness of the printed circuit board ranges from 0.2 mm∼10mm, preferably 0.4mm, 0.6mm, 0.8mm, 1.0mm or 1.6mm, a resistor is electrically connected to the printed circuit board, and the first and second assembling portion of the printed circuit board are each provided with slots and a hole for engaging with the first and second positioning portions of the frame.

7. The character display module as claimed in claim 1, wherein the frame is metal or non-metal, the first and second positioning portions of the frame each include positioning protrusions, and three of the four positioning protrusions are provided with a deformable end, respectively, the positioning protrusions of the first positioning portion are inserted in the slots and the hole of the first assembling portion in such a manner that the deformable ends of the positioning protrusions are locked against the printed circuit board after inserting through the slots, similarly, the positioning protrusions of the second positioning portion are inserted in the slots and the hole of the second assembling portion, and the deformable ends of the positioning protrusions are locked against the printed circuit board, the first and second assembling portions of the printed circuit board are oppositely arranged, the first and second connecting portions of the character organic light emitting diode are oppositely arranged, and the first and second connecting portions of the printed circuit board are oppositely arranged.

8. A character display module comprising:
a panel provided with a first connecting portion and a second connecting portion;
a polarizer located in a light path of the panel;
a printed circuit board provided with a first assembling portion and a second assembling portion and being provided at an inner side of the first assembling portion with a first connecting portion to be aligned with the first connecting portion of the panel, and provided at an inner side of the second assembling portion with a second connecting portion to be aligned with the second connecting portion of the panel;
a drive controller including a panel-control device and a panel-drive device;
a plurality of conductive elements disposed between the panel and the printed circuit board and being in contact with the first connecting portion of the printed circuit board and the first connecting portion of the panel, and in contact with the second connecting portion of the printed circuit board and the second connecting portion of the panel, respectively, and the panel is driven and controlled by the panel-control device and the panel-drive device of the drive controller; and
a frame provided with a first positioning portion and a second positioning portion which are to be engaged with the assembling portion and the second assembling portion of the printed circuit board, respectively, so that the panel is positioned on the printed circuit board by the frame.

9. The character display module as claimed in claim 8, wherein the panel is a character organic light emitting diode.

10. The character display module as claimed in claim 8, wherein the first and second assembling portions of the printed circuit board are oppositely arranged, the first and second connecting portions of the character organic light emitting diode are oppositely arranged, and the first and second connecting portions of the printed circuit board are oppositely arranged.
